# EUROPÄISCHE PATENTSCHRIFT

(11) **EP 4 099 361 B1**
(45) Veröffentlichungstag und Bekanntmachung des Hinweises auf die Patenterteilung: **12.06.2024**
(21) Anmeldenummer: 22176495.4
(22) Anmeldetag: 31.05.2022
(51) Int. Cl.: H01J 37/32, B01J 19/08, H01J 37/34, H05H 1/24

(54) **PLASMAREINIGUNGSANLAGE FÜR KLEINTEILE SOWIE VERFAHREN ZUM BETRIEB EINER PLASMAREINIGUNGSANLAGE**
PLASMA CLEANING SYSTEM FOR SMALL PARTS AND METHOD FOR OPERATING A PLASMA CLEANING SYSTEM
SYSTÈME DE NETTOYAGE AU PLASMA POUR PETITES PIÈCES ET PROCÉDÉ DE FONCTIONNEMENT D'UN SYSTÈME DE NETTOYAGE AU PLASMA

(30) Priorität: 04.06.2021 DE 102021114452
(43) Veröffentlichungstag der Anmeldung: 07.12.2022
(73) Patentinhaber: AixACCT mechatronics GmbH, 52249 Eschweiler Nordrhein-Westfalen (DE)
(72) Erfinder: Diederen, Wolfgang, 52249 Eschweiler (DE); Bungenberg, Thomas, 52249 Eschweiler (DE); Nonhoff, Sven, 52249 Eschweiler (DE)
(74) Vertreter: Naeven, Ralf

(56) Entgegenhaltungen:
- EP-A1- 2 891 729
- DE-A1-102004 044 357
- DE-C1- 19 609 804

## Beschreibung

Die Erfindung betrifft eine Plasmareinigungsanlage für Kleinteile gemäß dem Oberbegriff des Anspruchs 1 sowie ein Verfahren zum Betrieb einer Plasmareinigungsanlage.

Diverse Prozesse in der Produktionstechnik setzen sehr saubere Oberflächen voraus. Dies gilt insbesondere für Lackierprozesse von Großserienteilen, bei denen heutzutage vornehmlich wasserbasierte Lackierungen eingesetzt werden, die in der Regel im Vergleich zu lösemittelbasierten Lackierungsverfahren eine höhere Reinheit der zu behandelnden Oberfläche voraussetzen. Bei den Reinigungsprozessen selbst wird aus Umweltgesichtspunkten ebenfalls zunehmend auf die Verwendung reiner Lösemittel verzichtet. Bei wasserbasierten Reinigungsprozessen können allerdings lackbenetzungsstörende Substanzen auf der Oberfläche verbleiben.

Mit Hilfe von Plasmareinigungsanlagen lassen sich auch kleine Restmengen von störenden Substanzen mit großer Sicherheit entfernen, z.B. mittels Einsatzes von Niederdruckplasmen, die typischerweise in einem Druckbereich von 0,1-0,4 mbar arbeiten und somit anders als Plasmen im Normalatmosphärenbereich auch in kleine Ritzen und Spalten der zu behandelnden Werkstücke eindringen und sich problemlos in einem größeren Volumen einer Plasmakammer ausbreiten können.

Sie eignen sich daher in besonderer Weise zur Anwendung bei Kleinteilen, die als Schüttgut vorliegen können. Die Kleinteile werden typischerweise zur Reinigung in Körbe oder Trommeln gefüllt. Die hier betroffene Erfindung ist allerdings nicht auf die Anwendung von Niederdruckplasmen beschränkt.

Aus der EP 2884824 A1 ist eine Plasmareinigungsanlage der eingangs genannten Art bekannt. Zur Reinigung der Kleinteile werden diese in mehrere Trägereinrichtungen eingeführt, die wiederum hängend in eine Aufnahmeeinheit platziert werden. Die Aufnahmeeinheit befindet sich in einer druckdicht abschließbaren Reinigungskammer und kann für die Reinigung um eine horizontale Drehachse gedreht werden, so dass die Trägereinrichtungen derart um die Drehachse herum geführt werden, dass jede der Trägereinrichtungen stets mit derselben Seitenwand der Drehachse zugewandt ist. Aufgrund der Drehbewegung und der Gravitationskraft werden somit die Kleinteile in der jeweiligen Trägereinrichtung ständig durchmischt. An die Reinigungskammer, die unter Vakuum gesetzt werden kann, grenzt eine Plasmaerzeugungseinrichtung. Das in der Plasmaerzeugungseinrichtung erzeugte Plasma breitet sich in der Reinigungskammer aus, um in der gewünschten Weise reinigend auf die Kleinteile einzuwirken. Zum Beladen der Aufnahmeeinheit werden die Trägereinrichtungen durch eine Tür in die Reinigungskammer eingeführt und durch diese Tür nach dem Reinigungsprozess entnommen.

Aus der DE 4141805 A1 ist eine weitere Plasmareinigungsanlage gemäß dem Oberbegriff des Anspruchs 1 bekannt, mit der Kunststoffteile mittels eines Niedertemperaturplasmas behandelt werden. Die Kunststoffteile werden in kleinen Säcken über eine verschließbare Tür offensichtlich manuell in eine drehbare Aufnahmeeinheit platziert, die in einer zylindrischen Vakuumkammer angeordnet ist. Mit außerhalb oder innerhalb der Vakuumkammer angeordneten Mitteln zur Erzeugung einer Hochfrequenz oder einer Radiofrequenz kann in der Vakuumkammer bei eingeleitetem Sauerstoff ein Niederdruckplasma erzeugt werden. Die Aufnahmeeinheit dreht in einer Ausführungsform um eine horizontale Drehachse. Es ist allerdings auch offenbart, die gesamte Vakuumkammer mitsamt der Aufnahmeeinheit mittels einer Schwenkvorrichtung um eine zur Drehachse der Aufnahmeeinheit senkrechten Schwenkachse zu schwenken, wobei der Grund für diese Maßnahme in der genannten Druckschrift nicht erwähnt ist.

Der vorgenannte Stand der Technik hat den Nachteil, dass die Handhabung der zu reinigenden Kleinteile aufwendig ist, da sie zunächst in gesonderte Trägereinrichtungen oder kleine Säcke gefüllt werden, bevor diese in die eigentliche Aufnahmeeinheit verbracht werden.

Die DE 10 2004 044 357 A1 offenbart eine Plasmareinigungsanlage, bei der ein in einem Lagerkörper gelagerter, als Walze oder Kugel ausgeführter Rotationskörper zwei durch eine Trennwand abgeteilte Bauteil-Aufnahmekammern aufweist. In einer ersten Position des Rotationskörpers wird über eine Beladeöffnung des Lagerkörpers ein Bauteil aufgenommen. Durch Rotation des Rotationskörpers in eine zweite Position wird die Aufnahmekammer einer Prozesskammer gegenüber positioniert, um das Bauteil einer Plasma-Reinigungsbehandlung zu unterziehen. Anschließend wird der Rotationskörper in eine dritte Position weitergedreht, sodass das gereinigte Bauteil der Schwerkraft folgend über eine Entladeöffnung des Lagerkörpers aus der Aufnahmekammer herausfällt und die Vorrichtung verlassen kann. In der dritten Position kann in die zweite Aufnahmekammer desselben Rotationskörpers ein neues Bauteil eingefügt werden. Zum Betrieb der Plasmareinigungsanlage gemäß dieses Standes der Technik ist es somit erforderlich, dass eine ständige Rotation des Rotationskörpers mit derselben Rotationsrichtung durchgeführt wird.

Die EP 2891729 A1 offenbart eine Trommelsputtervorrichtung, die für Kleinteile geeignet ist und bei der eine rohrförmige Trommel als Aufnahmeeinheit für die Kleinteile innerhalb eines Vakuumbehälters in vertikaler Richtung verschwenkbar ist. Hierfür ist die Trommel, die der diesseitigen Aufnahmeeinheit entspricht, an einer L-förmigen Halterung fixiert, an der zwei Motoren derart angreifen, dass sowohl die genannte Schwenkbewegung um eine horizontale Achse als auch eine Drehbewegung der Trommel um ihre Längsachse möglich sind.

Aus der DE 196 09 804 C1 ist eine Vorrichtung zum Beschichten von Kleinteilen bekannt, bei der in der Mitte eines Drehkorbs zwei Plasmabeschichtungsquellen 20 angeordnet sind. Die Kleinteile können vor dem Beschichten mittels eines ECR-Plasmas gereinigt werden. Ein Schwenken des Drehkorbs ist nicht vorgesehen.

Der hier betroffenen Erfindung liegt das technische Problem zugrunde, eine Plasmareinigungsanlage für Kleinteile sowie ein Verfahren zum Betrieb einer Plasmareinigungsanlage der eingangs genannten Art zur Verfügung zu stellen, welche eine erleichterte Handhabung der Kleinteile, vorzugsweise eine verbesserte Automatisierbarkeit erlaubt.

Bei der Plasmareinigungsanlage der eingangs genannten Art wird das technische Problem mit den kennzeichnenden Merkmalen des Anspruchs 1 gelöst. Hinsichtlich des Verfahrens der eingangs genannten Art wird das technische Problem mit den Merkmalen des Anspruchs 9 gelöst. Bevorzugte Ausführungsbeispiele der erfindungsgemäßen Plasmareinigungsanlage sowie des Verfahrens ergeben sich aus den abhängigen Ansprüchen.

Demnach wird bei einer Plasmareinigungsanlage für Kleinteile, umfassend eine Reinigungskammer, Plasmaerzeugungsmittel zur Erzeugung eines Plasmas und eine in der Reinigungskammer angeordnete Aufnahmeeinheit zur Aufnahme der Kleinteile, vorgeschlagen, dass die Aufnahmeeinheit innerhalb der Reinigungskammer um mindestens 30°, vorzugsweise um mindestens 40°, weiter vorzugsweise um mindestens 50°, weiter vorzugsweise um mindestens 55 ° zwischen einer Reinigungsposition und einer Belade-/Entnahmeposition schwenkbar ist.

Mit dem Begriff Kleinteile sind Teile gemeint, die als Schüttgut behandelt werden dürfen und für eine Plasmaanwendung unter Vakuum geeignet sind. Hierzu können insbesondere pulverförmige oder körnige Materialien oder definierte Werkstücke, wie zum Beispiel Dichtungsringe, Bolzen, Scheiben, Muttern, Schrauben, Nägel oder speziell nach Kundenspezifikation produzierte Teile gehören.

Mit der erfindungsgemäßen Plasmareinigungsanlage kann eine neue Befülltechnik für die Aufnahmeeinheit realisiert werden. Zudem kann die Aufnahmeeinheit von einer optimierten Position für die Befüllung in eine optimierte Position für die Beaufschlagung mit dem reinigenden Plasma geschwenkt werden und umgekehrt. Die Reinigungsposition und damit der geeignete Schwenkwinkel können so gewählt werden, dass bei gegebener Form der Aufnahmeeinheit eine unter Berücksichtigung einer Durchmischung der Kleinteile und bei möglichst guter Reinigungswirkung des Plasmas ein optimierter Füllstand der Aufnahmeeinheit erreicht werden kann. Bevorzugt wird eine Reinigungsposition, bei der eine Mittellängsachse der Aufnahmeeinheit, bei drehbarer Aufnahmeeinheit ist dies die Drehachse, einen Winkel von 40° bis 60° zur Vertikalen einnimmt. Weitere bevorzugte Winkelbereiche sind oben genannt.

Die erfindungsgemäße Plasmareinigungsanlage kann auch so ausgebildet sein, dass in der Belade-/Entnahmeposition die Aufnahmeöffnung der Aufnahmeeinheit einer verschließbaren Tür der Reinigungskammer gegenüberliegt. Dies erleichtert die Befüllung der Aufnahmeeinheit. Insbesondere kann die verschließbare Tür so angeordnet sein, dass die Befüllung von oben, d. h. der Gravitationskraft folgend, durchgeführt werden kann, zum Beispiel auch durch eine Schüttbewegung.

Des Weiteren kann die erfindungsgemäße Plasmareinigungsanlage auch so ausgebildet sein, dass die Aufnahmeeinheit aus der Reinigungskammer entnehmbar ist. Die Aufnahmeeinheit kann somit bereits außerhalb der Reinigungskammer befüllt und nach dem Reinigungsprozess auch außerhalb der Reinigungskammer entleert werden. Insbesondere kann die Aufnahmeeinheit mitsamt darin enthaltenen Kleinteilen bereits vor dem Einfügen in die Reinigungskammer vorherigen vorbereitenden Prozessschritten zugeführt worden sein, sodass sich die erfindungsgemäße Plasmareinigungsanlage verfahrenstechnisch und/oder räumlich in eine mit weiteren Elementen eines Vorrichtungssystems durchführbare Prozessabfolge integrieren lässt.

Insbesondere ist es möglich, eine entnehmbare Aufnahmeeinheit automatisiert mit einer Greifvorrichtung, welche Teil des Vorrichtungssystems sein kann, in die Reinigungskammer einzubringen oder aus ihr zu entnehmen. Mit der Greifvorrichtung kann die Aufnahmeeinheit vor der mit der Plasmareinigungsanlage durchgeführten Reinigung auch automatisiert vorbereitenden Schritten und/oder nach der Reinigung nachbereitenden Schritten zugeführt werden. Zu den vorbereitenden Schritten kann insbesondere eine Vorreinigung, z.B. unter Einsatz von Wasser gehören, da eine Plasmareinigungsanlage in der Regel nicht für große Mengen an Verschmutzung, sondern vorrangig zum Entfernen für hartnäckige Verschmutzungen, beispielsweise mit lackbenetzungsstörenden Substanzen, gedacht ist. Zu den nachbereitenden Schritten können z.B. Lackieren, Galvanisieren, Beschichten jeglicher Art oder eine Verpackung der Kleinteile gehören. Für nachbereitende Schritte können die Kleinteile in andere Behälter oder Trageeinrichtungen umgefüllt werden.

Die erfindungsgemäße Plasmareinigungsanlage kann ein an einer Drehantriebswelle angeordnetes Drehantriebselement zum Antrieb einer Drehbewegung der Aufnahmeeinheit um eine Aufnahmeeinheit-Rotationsachse aufweisen. Mit einer Drehung der Aufnahmeeinheit können darin befindliche Kleinteile durchmischt werden. Bei dem Drehantriebselement kann es sich zum Beispiel um ein Ritzel handeln, welches in ein an der Aufnahmeeinheit oder einer Halterung für die Aufnahmeeinheit angeordnetes Kronenrad eingreift. Andere Getriebevarianten können alternativ eingesetzt werden.

Des Weiteren kann die erfindungsgemäße Plasmareinigungsanlage so ausgebildet sein, dass sie eine Schwenkwelle zur Ausführung der Schwenkung der Aufnahmeeinheit aufweist.

Dabei können eine Schwenkwellen-Rotationsachse der Schwenkwelle und die Aufnahmeeinheit-Rotationsachse in einer zu beiden Rotationsachsen senkrechten Richtung zueinander einen Rotationsachsenabstand aufweisen. Vorzugsweise ist der Rotationsachsenabstand derart, dass zum einen eine Schwenkbewegung der Aufnahmeeinheit zwischen der Reinigungsposition und der Belade-/Entnahmeposition kollisionsfrei und zum anderen in der Reinigungsposition der Abstand zwischen Aufnahmeeinheit und den Plasmaerzeugungsmitteln minimiert ist. Ein möglichst geringer Abstand zwischen Aufnahmeeinheit und den Plasmaerzeugungsmittel ist einer hohen Effizienz der Reinigung dienlich. Ein möglichst geringer Abstand kann zwar dadurch erreicht werden, dass die Aufnahmeeinheit nach der Schwenkbewegung in die Reinigungsposition hinein mit einer Translationsbewegung auf die Plasmaerzeugungsmittel zu bewegt wird. Durch eine geschickte Wahl der Position der Schwenkwellen-Rotationsachse kann jedoch auf eine solche Translationsbewegung und die Anordnung hierfür erforderlicher Antriebsmittel verzichtet werden. Der optimale Rotationsachsenabstand ist dabei abhängig zum einen vom Schwenkwinkel der Schwenkbewegung und zum anderen von der Geometrie der Aufnahmeeinheit und der Plasmaerzeugungsmittel oder von Halterungselementen für die Plasmaerzeugungsmittel.

Aus geometrischen Gründen ergibt sich für kleinere Schwenkwinkel ein größerer Abstand zwischen dem Schwenkzentrum der Aufnahmeeinheit und den Plasmaerzeugungsmitteln als bei größeren Winkeln, während der Rotationsachsenabstand zwischen der Dreh- und der Schwenkachse bei kleineren Winkeln kleiner ist als bei größeren Winkeln. Als besonders sinnvoll hat sich ein Schwenkwinkel von 55° bis 60° aus der Belade-/Entnahmeposition mit vertikaler Aufnahmeeinheit-Rotationsachse heraus erwiesen. Hierbei kann die Lagerung der Dreh- und Schwenkeinheit sehr kompakt unterhalb der Aufnahmeeinheit oder einer Haltevorrichtung für die Aufnahmeeinheit gebaut werden, während sich eine sehr gute Durchmischung der Teile realisieren lässt bei moderaten Drehzahlen der Aufnahmeeinheit.

Es kann vorteilhaft sein, die erfindungsgemäße Plasmareinigungsanlage so auszubilden, dass die Drehantriebswelle und die Schwenkwelle eine gemeinsame Rotationsachse aufweisen. Auf diese Weise bleibt die Position des Drehantriebselements auch bei einer Schwenkung der Aufnahmeeinheit unverändert. Damit die Drehung der Aufnahmeeinheit unabhängig von ihrer Schwenkbewegung erfolgen kann, sind die Drehantriebswelle und die Schwenkwelle derart gestaltet und gelagert, dass sie unabhängig voneinander rotieren können.

Ein Motor oder mehrere Motoren für den Antrieb des Drehantriebselements und der Schwenkbewegung sind bevorzugt außerhalb der Reinigungskammer angeordnet. Die Kraftübertragung erfolgt über geeignete Durchführungen.

Des Weiteren kann die erfindungsgemäße Plasmareinigungsanlage so ausgebildet sein, dass in der Reinigungsposition die Aufnahmeöffnung den Plasmaerzeugungsmitteln zugewandt ist. Dabei kann es insbesondere vorteilhaft sein, wenn die Aufnahmeeinheit-Rotationsachse mittig oder im Wesentlichen mittig durch die Mittellängsachse des Plasmaerzeugungsmittels verläuft, sodass eine weitgehend symmetrische Anordnung gegeben sein kann. Insbesondere kann auf diese Weise die Aufnahmeeinheit möglichst nahe an das Plasmaerzeugungsmittel angeordnet werden, sodass das erzeugte Plasma zuverlässig die zu reinigenden Kleinteile erreicht.

Im Folgenden wird ein vorteilhaftes Ausführungsbeispiel der erfindungsgemäßen Plasmareinigungsanlage und des erfindungsgemäßen Verfahrens anhand von Figuren dargestellt.

Es zeigt schematisch:
- Fig. 1:: eine geschlossene Plasmareinigungsanlage mit einer Aufnahmeeinheit in Reinigungsposition,
- Fig. 2:: die Plasmareinigungsanlage mit der Aufnahmeeinheit in Belade-/Entnahmeposition,
- Fig. 3:: die Plasmareinigungsanlage gemäß Fig. 1 mit Blick auf eine Schwenkwelle, und
- Fig. 4:: schematische Darstellung der Aufnahmeeinheit in zwei Schwenkpositionen.

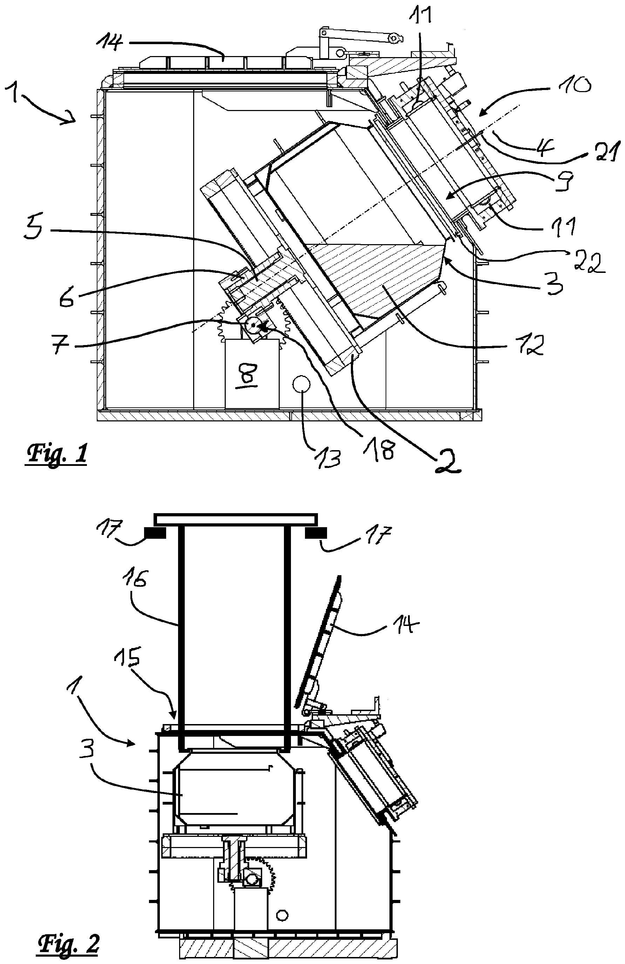

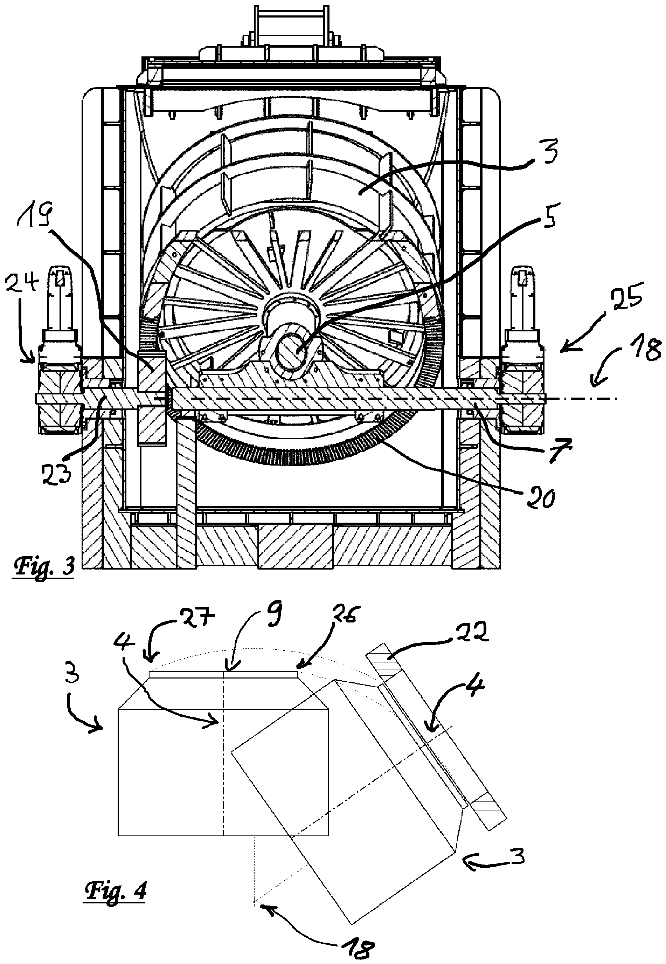

In einem Querschnitt zeigt Fig. 1 eine Reinigungskammer 1, in der auf einer Haltevorrichtung 2 eine Aufnahmeeinheit 3 in Form einer Trommel angeordnet ist. Die Aufnahmeeinheit 3 ist über die eine Aufnahmeeinheit-Drehachse 5 aufweisende Haltevorrichtung 2 mittelbar um eine Aufnahmeeinheit-Rotationsachse 4 drehbar gelagert. Die Aufnahmeeinheit-Drehwelle 5 ist in einem Drehlager 6 gelagert, welches wiederum an einer auf einem Stützlager 8 abgestützten Schwenkwelle 7 fixiert ist. Ein in Fig. 1 nicht dargestellter, vorzugsweise außerhalb der Reinigungskammer 1 angeordneter Schwenkantriebmotor 25 (siehe Fig. 3) ermöglicht eine gesteuerte Schwenkung der Haltevorrichtung 2 und damit der Aufnahmeeinheit 3 um eine Schwenkwellen-Rotationsachse 18 der Schwenkwelle 7. Des Weiteren sind in der Reinigungskammer 1 mit einem Ritzel 19 und einem Zahnrad in Form eines an der Unterseite der Haltevorrichtung 2 umlaufenden Kronenrads 20 Teile eines Getriebes für eine Drehbewegung der Aufnahmeeinheit 3 angeordnet.

Die Aufnahmeeinheit 3 befindet sich in der Darstellung der Fig. 1 mit der gegebenen Stellung der Schwenkwelle 7 in einer Reinigungsposition, bei der die Aufnahmeeinheit 3 mit ihrer Aufnahmeöffnung 9 auf eine Plasmaerzeugungseinheit 10 hin ausgerichtet ist. In der Plasmaerzeugungseinheit 10, welche über einen Fixieradapter 22 an der Reinigungskammer 1 fixiert ist, wird in bekannter Weise mittels einer Antenne 11 in Form einer Spule oder alternativ mit Elektroden ein elektromagnetisches Wechselfeld, vorzugsweise ein Hochfrequenzfeld mit beispielsweise 13,56 MHz erzeugt, während gleichzeitig bei starkem Unterdruck durch einen hier symbolisch angedeuteten Stutzen 21 aus einer nicht dargestellten Sauerstoffquelle Sauerstoff in die Plasmaerzeugungseinheit 10 und damit in die Reinigungskammer 1 eingegeben wird.

Im Hochfrequenzfeld zerfallen Bestandteile des Sauerstoffs in ein Plasma, welches in bekannter Weise reinigend auf in der Aufnahmeeinheit 3 befindliche Kleinteile 12 wirkt. Die Kleinteile 12 sind in Fig. 1 vereinfacht als zusammenhängende Masse dargestellt. Tatsächlich handelt es sich um eine Vielzahl von Einzelteilen. Über eine Absaugöffnung 13 wird der Sauerstoff aus der Reinigungskammer 1 permanent abgesaugt, wobei in der Reinigungskammer 1 der für die Bildung des Plasmas nötige Unterdruck aufrechterhalten wird.

Während das Plasma auf die Kleinteile 12 wirkt, wird die Aufnahmeeinheit 3 in der Regel permanent um die Aufnahmeeinheit-Rotationsachse 4 gedreht, sodass es zu einer ständigen Durchmischung der Kleinteile 12 kommt.

Fig. 2 zeigt schematisch die Reinigungskammer 1 der Fig. 1, wobei diesmal die Aufnahmeeinheit 3 in einer aufrechten Position, der Belade-/Entnahmeposition, zu sehen ist. Die Kleinteile 12 (Fig. 1) sind in Fig. 2 nicht dargestellt, sollen gleichwohl in der Aufnahmeeinheit 3 enthalten sein. Die Reinigungskammer 1 ist belüftet und eine in Fig. 1 noch verschlossene Tür 14 der Reinigungskammer 1 geöffnet, welche somit eine Belade-/Entnahmeöffnung 15 der Reinigungskammer 1 freigibt. Durch die Belade-/Entnahmeöffnung 15 hindurch greift eine Greifereinheit 16 auf die Aufnahmeeinheit 3 zu, um diese aus der Reinigungskammer 1 zu entfernen. Die Greifereinheit 16 selbst kann manuell oder über in Fig. 2 durch Schienen 17 lediglich symbolisierte Mittel automatisiert geführt und zum Beispiel für eine Greifbewegung gesteuert werden.

Alternativ zur Verwendung einer Greifereinheit 16 für das Einsetzen einer bereits befüllten Aufnahmeeinheit 3 könnte die bereits in der Reinigungskammer 1 befindliche Aufnahmeeinheit 3 auch durch eine Schüttbewegung durch die Belade-/Entnahmeöffnung 15 hindurch befüllt werden.

Fig. 3 zeigt in einem Teilschnitt die Reinigungskammer 1 in einer zur Fig. 1 senkrechten Blickrichtung. Die Aufnahmeeinheit 3 befindet sich weiterhin in der Reinigungsposition.

An der Halterungsvorrichtung 2 ist das umlaufende Kronenrad 20 fixiert, in das das Ritzel 19 eingreift. Das Ritzel 19 wird über eine Drehantriebswelle 23 mittels eines Drehantriebmotors 24 angetrieben. Auf diese Weise wird eine Drehbewegung der Aufnahmeeinheit 3 um die Aufnahmeeinheit-Drehachse 5 bewirkt. Ein zweiter Motor 25 treibt die Schwenkwelle 7 zur Rotation um die Schwenkwellen-Rotationsachse 18 an. Die Schwenkwelle 7 und die Drehantriebswelle 23 sind derart in einer Linie zueinander zugeordnet, sodass die Schwenkwellen-Rotationsachse 18 gleichzeitig die Rotationsachse der Drehantriebswelle 23 ist. Hierfür kann die Schwenkwelle 7 drehbar an der Drehantriebswelle 23 gelagert sein.

Fig. 4 schließlich zeigt schematisch die Aufnahmeeinheit 3 zum einen in der Belade-/Entnahmeposition (links) mit vertikal ausgerichteter Aufnahmeeinheit-Rotationsachse 4 und in der Reinigungsposition (rechts) mit hierzu schräggestellter Aufnahmeeinheit-Rotationsachse 4 relativ zu der Schwenkwellen-Rotationsachse 18 und dem Fixieradapter 22 für die in Fig. 4 nicht dargestellte Plasmaerzeugungseinheit 10 (siehe Fig. 1). Die bei der Schwenkbewegung in die Reinigungsposition vollzogenen Wege einer vorlaufenden Kante 26 sowie einer nachlaufenden Kante 27 der Aufnahmeöffnung 9 sind gestrichelt wiedergegeben. Mit der gewählten Position der Schwenkwellen-Rotationsachse 18 wird eine Kollision zwischen der Aufnahmeeinheit 3 und dem Fixieradapter 22 vermieden und gleichzeitig der Abstand zwischen Aufnahmeeinheit 3 und dem Fixieradapter 22 möglichst gering gehalten.

### Bezugszeichenliste

- 1: Reinigungskammer
- 2: Haltevorrichtung
- 3: Aufnahmeeinheit
- 4: Aufnahmeeinheit-Rotationsachse
- 5: Aufnahmeeinheit-Drehwelle
- 6: Drehlager
- 7: Schwenkwelle
- 8: Stützlager
- 9: Aufnahmeöffnung
- 10: Plasmaerzeugungseinheit
- 11: Antenne
- 12: Kleinteile
- 13: Absaugöffnung
- 14: Tür
- 15: Belade-/Entnahmeöffnung
- 16: Greifereinheit
- 17: Schienen
- 18: Schwenkwellen-Rotationsachse
- 19: Ritzel
- 20: Kronenrad
- 21: Stutzen
- 22: Fixieradapter
- 23: Drehantriebswelle
- 24: Drehantriebmotor
- 25: Schwenkantriebmotor
- 26: Vorlaufende Kante
- 27: Nachlaufende Kante

## Patentansprüche

1. Plasmareinigungsanlage für Kleinteile, umfassend
a) eine Reinigungskammer (1),
b) Plasmaerzeugungsmittel (10) zur Erzeugung eines Plasmas und
c) eine in der Reinigungskammer (1) angeordnete, eine Aufnahmeöffnung (9) aufweisende Aufnahmeeinheit (3) zur Aufnahme der Kleinteile (12), wobei
d) in einer zur Beaufschlagung mit dem Plasma dienenden Reinigungsposition die Aufnahmeöffnung (9) den Plasmaerzeugungsmitteln (10) zugewandt ist,
**dadurch gekennzeichnet, dass**
e) die Plasmareinigungsanlage eingerichtet ist, die Aufnahmeeinheit (3) innerhalb der Reinigungskammer (1) um mindestens 30° von einer zum Beladen und Entnehmen der Kleinteile dienenden Belade-/Entnahmeposition in die Reinigungsposition und von der Reinigungsposition zurück in die Belade-/Entnahmeposition zu schwenken.

2. Plasmareinigungsanlage nach Anspruch 1, **dadurch gekennzeichnet, dass** in der Belade-/Entnahmeposition die Aufnahmeöffnung (9) der Aufnahmeeinheit (3) einer verschließbaren Tür der Reinigungskammer (1) gegenüberliegt.

3. Plasmareinigungsanlage nach Anspruch 1 oder 2, **dadurch gekennzeichnet, dass** die Aufnahmeeinheit (3) aus der Reinigungskammer (1) entnehmbar ist.

4. Plasmareinigungsanlage nach einem der vorhergehenden Ansprüche, **gekennzeichnet durch** ein an einer Drehantriebswelle (23) angeordnetes Drehantriebselement (24) zum Antrieb einer Drehbewegung der Aufnahmeeinheit (3) um eine Aufnahmeeinheit-Rotationsachse (4).

5. Plasmareinigungsanlage nach einem der vorhergehenden Ansprüche, **gekennzeichnet durch** eine Schwenkwelle (7) zur Ausführung der Schwenkung der Aufnahmeeinheit (3).

6. Plasmareinigungsanlage nach Anspruch 4 und 5, **dadurch gekennzeichnet, dass** eine Schwenkwellen-Rotationsachse (18) der Schwenkwelle (7) und die Aufnahmeeinheit-Rotationsachse (4) in einer zu beiden Rotationsachsen (18, 4) senkrechten Richtung zueinander einen Rotationsachsenabstand aufweisen.

7. Plasmareinigungsanlage nach Anspruch 6, **dadurch gekennzeichnet, dass** der Rotationsachsenabstand derart gewählt ist, dass eine Schwenkbewegung der Aufnahmeeinheit (3) zwischen der Reinigungsposition und der Belade-/Entnahmeposition kollisionsfrei und in der Reinigungsposition der Abstand zwischen Aufnahmeeinheit (3) und den Plasmaerzeugungsmitteln (10) minimiert ist.

8. Plasmareinigungsanlage nach einem der vorhergehenden Ansprüche mit Rückbezug auf Anspruch 4 und 5, **dadurch gekennzeichnet, dass** die Drehantriebswelle (23) und die Schwenkwelle (7) eine gemeinsame Rotationsachse aufweisen.

9. Verfahren zum Betrieb einer Plasmareinigungsanlage nach einem der Ansprüche 1 bis 8, bei dem
eine eine Aufnahmeöffnung (9) aufweisende Aufnahmeeinheit (3) innerhalb einer Reinigungskammer (1) um mindestens 30° von einer zum Beladen und Entnehmen von Kleinteilen (12) dienenden Belade-/Entnahmeposition in eine zur Beaufschlagung mit einem Plasma dienende Reinigungsposition und von der Reinigungsposition zurück in die Belade-/Entnahmeposition verschwenkt wird,
wobei in der Reinigungsposition die Aufnahmeöffnung (9) Plasmaerzeugungsmitteln (10) zugewandt ist und wobei
die Aufnahmeeinheit (3) außerhalb der Reinigungskammer (1) befüllt und nach dem Reinigungsprozess aus der Reinigungskammer (1) entnommen und außerhalb der Reinigungskammer (1) entleert wird.

10. Verfahren nach Anspruch 9, **dadurch gekennzeichnet, dass** die Aufnahmeeinheit mitsamt darin enthaltenen Kleinteilen bereits vor dem Einfügen in die Reinigungskammer vorherigen vorbereitenden Prozessschritten zugeführt wird.

11. Verfahren nach einem der Ansprüche 9 bis 10, **dadurch gekennzeichnet, dass** die Aufnahmeeinheit automatisiert mit einer Greifvorrichtung in die Reinigungskammer eingebracht oder aus der Reinigungskammer entnommen wird.

## Claims

1. Plasma cleaning system for small parts, comprising
a) a cleaning chamber (1),
b) plasma generating means (10) for generating a plasma and
c) a receiving unit (3), which is arranged in the cleaning chamber (1) and has a receiving opening (9), for receiving the small parts (12), wherein
d) in a cleaning position serving for exposure to the plasma the receiving opening (9) faces the plasma generating means (10),
**characterised in that**
e) the plasma cleaning system is designed to pivot the receiving unit (3) within the cleaning chamber (1) by at least 30° from a loading/removal position serving for loading and removing the small parts into the cleaning position and from the cleaning position back into the loading/removal position.

2. Plasma cleaning system according to claim 1, **characterised in that**, in the loading/removal position, the receiving opening (9) of the receiving unit (3) lies opposite a closable door of the cleaning chamber (1).

3. Plasma cleaning system according to claim 1 or 2, **characterised in that** the receiving unit (3) can be removed from the cleaning chamber (1).

4. Plasma cleaning system according to one of the preceding claims, **characterised by** a rotary drive element (24) arranged on a rotary drive shaft (23) for driving a rotational movement of the receiving unit (3) about a receiving unit axis of rotation (4).

5. Plasma cleaning system according to one of the preceding claims, **characterised by** a pivot shaft (7) for carrying out the pivoting of the receiving unit (3).

6. Plasma cleaning system according to claim 4 and 5, **characterised in that** a pivot shaft axis of rotation (18) of the pivot shaft (7) and the receiving unit axis of rotation (4) have a rotational axis spacing relative to one another in a direction perpendicular to both axes of rotation (18, 4).

7. Plasma cleaning system according to claim 6, **characterised in that** the rotational axis distance is selected in such a way that a pivoting movement of the receiving unit (3) between the cleaning position and the loading/removal position is collision-free and the distance between the receiving unit (3) and the plasma generating means (10) is minimised in the cleaning position.

8. Plasma cleaning system according to one of the preceding claims with reference back to claims 4 and 5, **characterised in that** the rotary drive shaft (23) and the pivot shaft (7) have a common axis of rotation.

9. Method for operating a plasma cleaning system according to one of claims 1 to 8, in which
a receiving unit (3) having a receiving opening (9) is pivoted within a cleaning chamber (1) by at least 30° from a loading/removal position serving for loading and removing small parts (12) into a cleaning position serving for exposure to a plasma and from the cleaning position back into the loading/unloading position, wherein
in the cleaning position, the receiving opening (9) faces plasma generating means (10), and wherein
the receiving unit (3) is filled outside the cleaning chamber (1) and is removed from the cleaning chamber (1) after the cleaning process and emptied outside the cleaning chamber (1).

10. Method according to claim 9, **characterised in that** the receiving unit, together with small parts contained therein, is already fed to previous preparatory process steps before being inserted into the cleaning chamber.

11. Method according to one of claims 9 to 10, **characterised in that** the receiving unit is automatically inserted into the cleaning chamber or is removed from the cleaning chamber with a gripping device.

## Revendications

1. Système de nettoyage au plasma pour petites pièces, comprenant
a) une chambre de nettoyage (1),
b) des moyens (10) de génération de plasma pour générer un plasma et
c) une unité de réception (3) disposée dans la chambre de nettoyage (1) et présentant une ouverture de réception (9) pour recevoir les petites pièces (12),
d) dans une position de nettoyage servant à l'exposition au plasma, l'ouverture de réception (9) étant tournée vers les moyens (10) de génération de plasma,
**caractérisé en ce que**
e) le système de nettoyage au plasma est agencé de façon à faire pivoter l'unité de réception (3) à l'intérieur de la chambre de nettoyage (1) d'au moins 30° depuis une position de chargement/prélèvement, servant au chargement et au prélèvement des petites pièces, dans la position de nettoyage et depuis la position de nettoyage en retour dans la position de chargement/prélèvement.

2. Système de nettoyage au plasma selon la revendication 1, **caractérisé en ce que**, dans la position de chargement/prélèvement, l'ouverture de réception (9) de l'unité de réception (3) est située en face d'une porte de la chambre de nettoyage (1) apte à être fermée.

3. Système de nettoyage au plasma selon la revendication 1 ou 2, **caractérisé en ce que** l'unité de réception (3) est apte à être retirée de la chambre de nettoyage (1).

4. Système de nettoyage au plasma selon l'une des revendications précédentes, **caractérisé par** un élément (24) d'entraînement en rotation disposé sur un arbre (23) d'entraînement en rotation, pour entraîner un mouvement de rotation de l'unité de réception (3) autour d'un axe de rotation (4) de l'unité de réception.

5. Système de nettoyage au plasma selon l'une des revendications précédentes, **caractérisé par** un arbre de pivotement (7) pour réaliser le pivotement de l'unité de réception (3).

6. Système de nettoyage au plasma selon les revendications 4 et 5, **caractérisé en ce qu'**un axe de rotation (18) de l'arbre de pivotement (7) et l'axe de rotation (4) de l'unité de réception présentent un écart d'axe de rotation dans une direction perpendiculaire aux deux axes de rotation (18, 4).

7. Système de nettoyage au plasma selon la revendication 6, **caractérisé en ce que** la distance entre les axes de rotation est choisie de telle sorte qu'un mouvement de pivotement de l'unité de réception (3) entre la position de nettoyage et la position de chargement/prélèvement soit exempt de collision et que, dans la position de nettoyage, la distance entre l'unité de réception (3) et les moyens (10) de génération de plasma soit minimisée.

8. Système de nettoyage au plasma selon l'une des revendications précédentes en référence aux revendications 4 et 5, **caractérisé en ce que** l'arbre d'entraînement en rotation (23) et l'arbre de pivotement (7) ont un axe de rotation commun.

9. Procédé de fonctionnement d'un système de nettoyage au plasma selon l'une des revendications 1 à 8, dans lequel une unité de réception (3), présentant une ouverture de réception (9), est pivotée d'au moins 30° à l'intérieur d'une chambre de nettoyage (1) depuis une position de chargement/prélèvement, servant au chargement et au prélèvement de petites pièces (12), jusqu'à une position de nettoyage servant à l'exposition à un plasma, et en retour depuis la position de nettoyage à la position de chargement/prélèvement,
dans la position de nettoyage, l'ouverture de réception (9) étant tournée vers des moyens (10) de génération de plasma et
l'unité de réception (3) étant remplie à l'extérieur de la chambre de nettoyage (1) et, après le processus de nettoyage, étant retirée de la chambre de nettoyage (1) et vidée à l'extérieur de la chambre de nettoyage (1).

10. Procédé selon la revendication 9, **caractérisé en ce que** l'unité de réception, ainsi que les petites pièces qu'elle contient, sont amenées aux étapes préparatoires précédentes du processus avant d'être insérées dans la chambre de nettoyage.

11. Procédé selon l'une des revendications 9 à 10, **caractérisé en ce que** l'unité de réception est introduite dans la chambre de nettoyage ou retirée de la chambre de nettoyage de manière automatisée en utilisant un dispositif de préhension.
